# EUROPEAN PATENT APPLICATION

(11) **EP 4 712 344 A1**
(43) Date of publication of application: **18.03.2026**
(21) Application number: 24200062.8
(22) Date of filing: 12.09.2024
(51) Int. Cl.: H03H 9/02, H03H 9/13, H03H 9/215, H03H 3/04

(54) **TUNING FORK RESONATOR**

(71) Applicant: Micro Crystal SA, 2540 Grenchen (CH)
(72) Inventor: DALLA PIAZZA, Silvio, 2610 St-Imier (CH); STAUB, Felix, 3425 Koppigen (CH)
(74) Representative: ICB SA

(57) **Abstract**

One aspect of the present invention is related to a tuning fork resonator having a design allowing reduced dimensions of resonators while maintaining a high quality factor.

## Description

### Technical field

The present invention is related to a tuning fork resonator having a geometry allowing reduced sizes of resonators while maintaining a high quality factor.

### Background

Tuning fork resonators generally comprise at least two tines (also called vibrating arms or beams) and at least one stem (or a base) coupling the tines. The stem and the tines are generally coplanar. Tuning fork resonators can be made for example of silicon or quartz. The tines are generally arranged parallel and symmetric to each other. The tines are generally provided with electrodes, as disclosed for example in EP3468037, or with piezoelectric strips, as disclosed for example in EP2278709. The electrodes or piezoelectric strips can be coupled to an alternative voltage causing the tines of the tuning fork to vibrate. Conventional tuning forks have their tines included in a vibration plane and vibrating within this vibration plane.

One feature of a resonator is its quality factor Q (also mentioned « Q factor » or « Q ») which is commonly defined as the ratio of the energy stored in the resonator to the energy lost by cycle of oscillation. The higher the value of the Q factor, the better is the resonance characteristics of the resonator. A high Q factor facilitates achieving a low resistance of the resonator.

One objective of resonator's manufacturers is to reduce the size of resonators while maintaining a high quality factor and the value of the resonance frequency. A main issue in miniaturization of low frequency flexural mode resonators is the decreasing quality factor Q leading to increasing resistance due to thermoelastic damping. Thermoelastic damping is the highest when the time of thermal relaxation τ (tau) of a resonator beam in direction of oscillation is equal to the reciprocal of the angular frequency ω=2πf of the resonance, i.e. if ω•τ=1.

Due to the thermo-mechanical properties of quartz we find ω•τ > 1 for common tuning fork resonators operating at 32768 Hz.

Downsizing a geometry given will make τ (tau) and thus ω•τ to decrease. As a consequence, Q will keep decreasing with size until ω•τ=1 is reached. For even smaller structures Q will re-increase.

As a counteraction, resonator design aims to maximize τ (tau), e.g. by etching grooves into the resonator beams on both sides, which turns the cross section of a beam into the shape of an H, leaving a thin membrane between the sidewalls. Examples of small piezoelectric resonators having this feature are described in document EP3468037 B1. Some of these solutions comprise etching a groove in the vibrating arms in order to reduce consumption of energy by providing a more homogeneous electrical field. On one hand, the grooves provide thermal insulation between the compressive and extensional side, which increases Q, lowering resistance. On the other hand, due to the thin and high border-walls the electric field is more homogenous and stronger, which increases motional capacitance and in turn lowers resistance. More particularly, each resonator beam comprises a first groove on a first side and a second groove on the opposite side such that the depth of the first groove and second groove are different. Miniaturization of such kind of resonators may be limited by their design's complexity and machining possibilities.

Apart from the main purpose of grooves, namely to increase the piezoelectric coupling due to their narrow high sidewalls, the thin membrane in between slows down thermalisation within the beam, which raises τ (tau). However, this technique only partially compensates for the decrease of the Q factor with size.

The outstanding thermal and mechanical properties of quartz make it the preferred material for tuning fork resonators.

There is a need to miniaturize tuning fork resonators, preferably quartz tuning fork resonators, and to provide new designs of such resonators in order to reach the regime ω•τ << 1 in quartz where Q re-increases to reasonable levels.

### Summary of the invention

The present invention aims to provide a tuning fork resonator having a reduced size and a relatively high quality factor Q.

In a first aspect, the present invention is related to a tuning fork resonator comprising :
- a stem having a first height extending from a first base to a second base, and ;
- a first resonator beam and a second resonator beam spaced from each other, coupled to the stem, and arranged in a plane substantially perpendicular to the height of the stem;
characterized in that the first resonator beam and the second resonator beam have a thickness comprised between 0.05% and 20% of the first height of the stem.

Preferably, the tuning fork resonator is configured such that to allow the resonator beams to oscillate in an out-of-plane mode.

Preferably, the first resonator beam comprises a first piezoelectric assembly, and the second resonator beam comprises a second piezoelectric assembly provided on their respective said surfaces, each of the first and second piezoelectric assemblies comprising :
- a first electrode layer over a surface of the resonator beam ;
- a piezoelectric layer over the first electrode, and ;
- a second electrode layer over the piezoelectric layer;
wherein :
- the first electrode layer of the first piezoelectric assembly and the second electrode layer of the second piezoelectric assembly are electrically coupled to a first mounting pad configured to be coupled to a first pole of an alternating electrical source, and ;
- the second electrode layer of the first piezoelectric assembly and the first electrode layer of the second piezoelectric assembly are electrically coupled to a second mounting pad configured to be coupled to an opposite pole of the alternating electrical source.

Preferably the stem and the resonator beams are made of quartz, preferably a Z-cut quartz. Other materials can also be selected such as langasite, GaPO₄ or partially oxidized silicon, or any compound having a crystalline orientation for which at least the first-order frequency-temperature coefficient of the resonator is zero or nearly zero, for example less than 1 ppm/K in absolute value. The resonance frequency f of tuning fork resonators in dependence of the temperature *T* can be approximated by *f*(*T*) = *β* · (*T* - *T_{Ref}*)² + *α* · (*T* - *T_{Ref}*) + *f*(*T_{Ref}*), where *T_{Ref}* is the reference temperature (typically 25°C) and α and β are the temperature coefficients of first and second order, respectively. For quartz and for *T_{Ref}* around 25°C, cut angles close to a z-cut exist for which α of tuning fork resonators is nearly zero, for example less than 1 ppm/K in absolute value. Consequently, *f*(*T*) is dominated by the second order term, yielding a parabolic frequency-temperature characteristic.

Preferably, the tuning fork resonator forms a body wherein the first resonator beam and the second resonator beam are integral with the stem.

Preferably, the tuning fork resonator further comprises an intermediate slice extending between the stem and the first and second resonator beams, the slice being coplanar with the first resonator beam and the second resonator beam and having preferably the same thickness as the first resonator beam and the second resonator beam. The slice may extend from one of the first of second base of the stem or from an intermediate position between the first base and second base of the stem.

Preferably, the thickness of the first and second resonator beams is comprised between 0.05 µm and 25 µm, preferably less than 10 µm.

Preferably, the height of the stem is comprised between 10 µm and 200 µm, preferably between 20 µm and 150 µm, more preferably between 80 µm and 125 µm.

Preferably, each of the first and second resonator beam 15a, 15b have a first end fixed to the stem 11 or to the slice 27, and a free end (unattached end), the first and second resonator beam further comprising :
- a main portion extending from their free end (unattached end) to a region at the proximity of their attached end and ;
- a flared portion which widens from their main portion towards their attached end.

In some embodiments, the main portion has a constant width.

In some embodiments, the free ends of the main portions of the first and second resonator beam comprises an additional mass or an enlarged portion providing an additional mass.

Preferably, the width of the stem is comprised between 50 µm and 200 µm, preferably between 80 µm and 125 µm.

Preferably, the width of the main portions of each of the first and second resonator beams is comprised between 10% and 45% of the width of the stem.

Preferably, the tuning fork resonator has a length inferior to 500 µm, preferably inferior to 400 µm.

Preferably, the stem has a thickness measured in the direction of the resonator beams, and each of the first and second resonator beams has a length which is superior to at least the half thickness of the stem.

Preferably, the stem comprises a tapered portion extending from a lateral side of the stem and/or from one of the first base or second base to a junction or an intermediate surface between the stem and the first and second resonator beams or to a junction or intermediate surface between the stem and a slice connecting the resonator beams.

Preferably, the quality factor of the tuning fork resonator at 32768 Hz in vacuum is superior or equal to 5000, preferably superior or equal to 7500, more preferably superior or equal to 10000, preferably superior or equal to 15000.

### Brief description of the drawings

The goals, advantages and features of the invention will appear upon reading the following description, given solely by way of non-limiting example, and made with reference to the annexed drawings, in which
- the figure 1 shows a top view of a tuning fork resonator according to a first embodiment of the present invention ;
- the figure 2 shows a side view of a tuning fork resonator according to an embodiment of the present invention ;
- the figure 3 shows a schematic view of an embodiment of a tuning fork resonator comprising two piezoelectric strip assemblies and two mounting pads ;
- the figure 4a shows a top view of a tuning fork resonator according to a second embodiment of the present invention ;
- the figure 4b shows a top view of a tuning fork resonator according to a third embodiment of the present invention ;
- the figure 5a shows a top view of a tuning fork resonator according to a fourth embodiment of the present invention, and ;
- the figure 5b shows a side view of the tuning fork resonator according to the fourth embodiment of the present invention.

It is to be noted that unless stated otherwise, the drawings are not to scale and that variations can be made on the designs presented in the figures within the spirit of the present invention.

### Detailed description of the invention

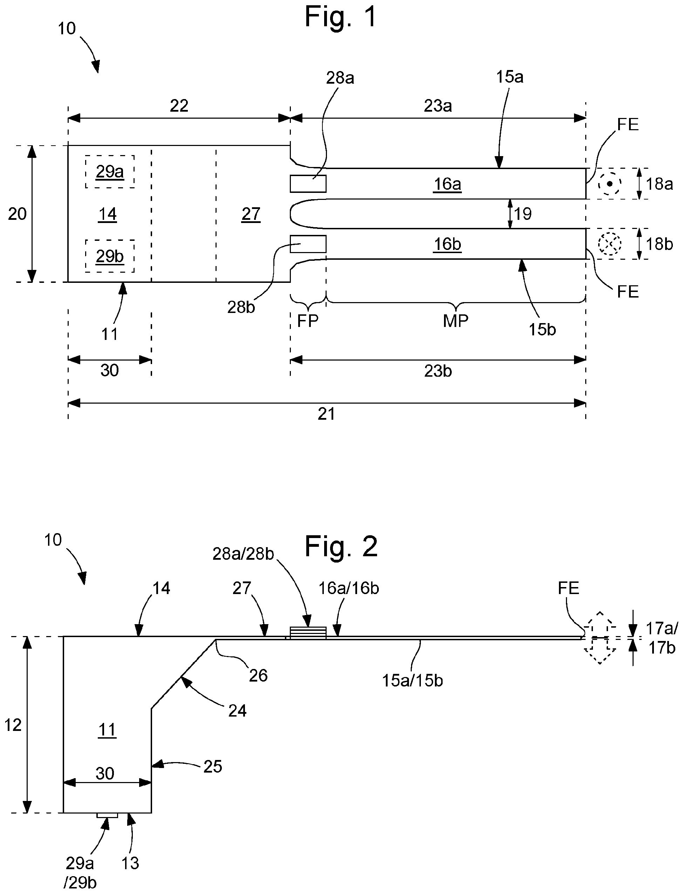

The present invention will be described in more detail here below with the support of the figures 1 and 2 which show respectively a top view and a side view of an embodiment of a tuning fork resonator according to the invention.

The tuning fork resonator 10 according to the invention comprises :
- a stem 11 having a first height 12 extending from a first base 13 to a second base 14, and ;
- a first resonator beam 15a and a second resonator beam 15b spaced from each other, coupled to the stem 11 and extending in a plane substantially perpendicular to the height 12 of the stem 11 ;
characterized in that the first resonator beam 15a and the second resonator beam 15b have a thickness 17a, 17b comprised between 0.05% and 20%, preferably between 0.1% and 10%, more preferably between 0.1% and 5%, even more preferably between 0.5% and 5% of the first height 12 of the stem 11. In the context herein, the term "coupled" refers to :
- a first element which is directly connected (physically joint or attached) to a second element or to ;
- a first element which is indirectly connected (physically joint or attached) to a second element through at least one further element.

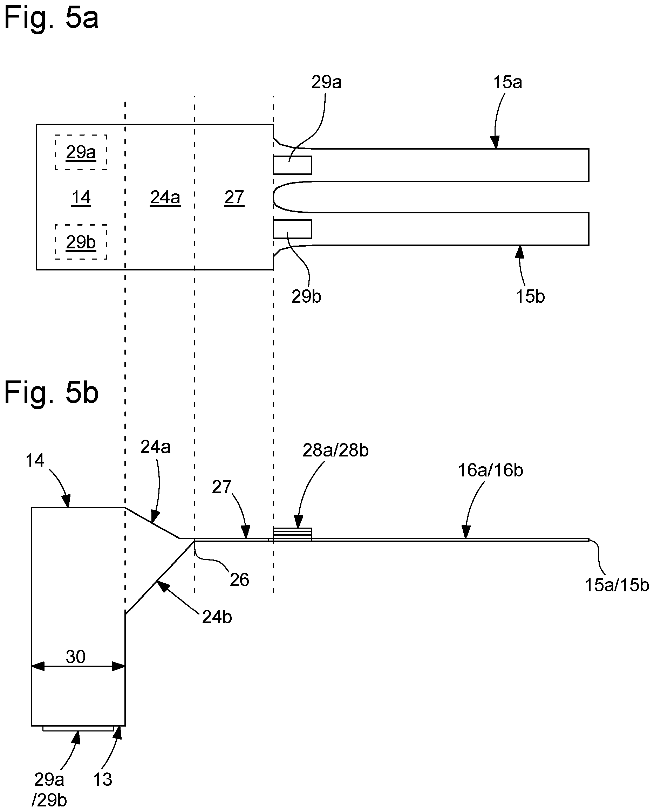

Preferably, an intermediate slice 27 extends between the stem 11 and the first resonator beam 15a and second resonator beam 15b. The intermediate slice 27 has preferably the same thickness as the first and second resonator beams 15a, 15b, and is coplanar with the first and second resonator beams 15a, 15b. The intermediate slice 27 may be also coplanar to one of the first base 13 or second base 14 of the stem 11. As shown in fig. 2, the intermediate slice 27 is coplanar with the second base 14. In an alternative embodiment, as shown in fig. 5b, the intermediate slice 27 may be positioned at an intermediate position between the first and second bases 13, 14 of the stem 11. In any case, the intermediate slice 27 is substantially perpendicular to the height 12 of the stem 11. The intermediate slice 27 is advantageous regarding the temperature turnover T0 and the decoupling of the resonator beams 15a, 15b from the stem 11. The first resonator beam 15a and a second resonator beam 15b have a first end attached to the intermediate slice 27, also mentioned « attached end » and a second end which is a free end, also mentioned « unattached end ».

The term « substantially perpendicular » refers to an axis, a plane or a surface perpendicular to another axis, plane or surface, with a tolerance of 5° or less, preferably of 1° or less. The expression "substantially perpendicular to the height of the stem" in the context of the present invention is referred to a perpendicular position of the first and second resonator beams relative to the height of the stem with a tolerance of 5° or less, preferably 1° or less, in absence of any electric field created across the resonator beams or any mechanical impulsion causing the first and second resonator beams to vibrate.

The first base 13 and the second base 14 are opposite to each other and are preferably substantially planar and preferably substantially parallel to each other. The term "substantially planar" encompasses surfaces that are generally planar or flat, although optionally comprising minor irregularities or interruptions such as a hole, but without affecting the general planar or flat appearance. The term "substantially parallel" refers to two substantially planar surfaces or axis parallel to each other, thereby forming an angle of 0° with each other with a tolerance of less than 5°, preferably less than 1°.

The term "resonator beam(s)" in the present disclosure can be referred to an arm, a tine, a cantilevered element, preferably having a length of at least 5 times greater than its width and/or its thickness and which is adapted to vibrate.

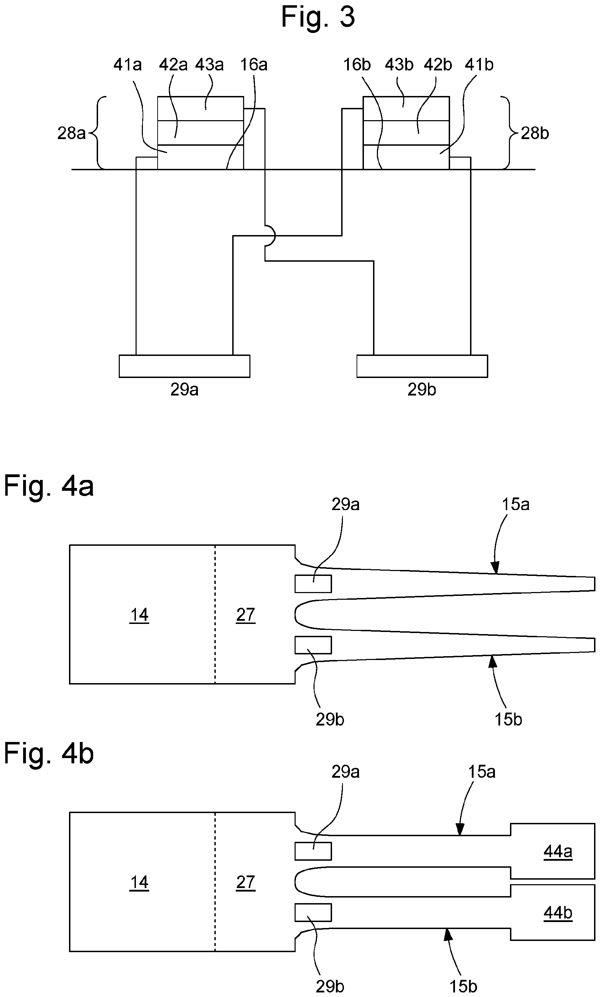

From a top view as shown in fig. 1, the first and second resonator beams 15a, 15b have a main portion MP, for example with a constant width. The shape of the main portions MP is not limited to rectangular and other adapted shapes can be designed, such as for example rectangular shapes with rounded or chamfered free ends or tempered shapes with changing width along the length direction as shown for example in fig. 4a.

In some embodiments, the free ends of the main portions of the first and second resonator beam 15a, 15b comprises an additional mass or an enlarged portion providing an additional mass as shown in fig. 4b. This additional mass may allow to reduce the length of the resonator beams.

The tuning fork resonator is configured such that to allow the resonator beams to oscillate in an out-of-plane mode. The high ratio of resonator beam thickness 17a/17b to the stem height 12, leads to high inertia of the stem 11 compared to the resonator beams 15a/15b. Consequently, the stem takes over residual movement more easily than if the stem 11 and the resonator beams 15a, 15b had a similar thickness. It has been found that when the first and second resonator beams 15a, 15b are submitted to an oscillating mode out-of-plane, the residual torsional movement of the resonator beams 15a, 15b out of plane mode is negligible due to the big mass of the stem 11, being thicker than the resonator beams. The term "oscillating mode out-of-plane" in the context of the present disclosure refers to a vibration or oscillation mode of two resonator beams wherein the two resonator beams 15a, 15b at rest are included in a plane (or coplanar), and vibrate out of the said plane and in opposite direction (in antiphase) under action of an electric field applied through the resonator beams or under action of a mechanical impulsion substantially orthogonal to the said plane. Although it would be possible to use the common in-plane mode of a tuning fork resonator, an out of plane mode is chosen for the ease of fabrication. The geometry of the tuning fork resonator as described herein above, preferably in combination with any one of the embodiments presented here below allows to reduce the size of tuning fork resonators while maintaining a relatively high quality factor Q at low frequency.

The stem and the first and second resonator beams are made of quartz, preferably a Z-cut quartz. Other materials can also be selected such as langasite, GaPO4 or partially oxidized silicon, or any compound having a crystalline orientation for which at least the first-order frequency-temperature coefficient of the resonator is zero or nearly zero, for example less than 1 ppm/K in absolute value. As it will be described here below, the resonator beams 15a, 15b according to the present invention are configured to oscillate in out-of-plane mode. Z-cut quartz is well known in the art and is advantageously chosen due to the ease of fabrication. As piezoelectric coupling for an out-of-plane mode in quartz is weak, piezoelectric assemblies 28a, 29a are used for actuation. This results in separation of mechanical and electrical properties, which is advantageous, as both domains can be optimized independently.

Advantageously, the tuning fork resonator is made of one piece wherein the first resonator beam 15a and second resonator beam 15b are integral with the stem 11.

In one embodiment as represented in figure 2, each of the first and second resonator beams 15a, 15b comprise a surface 16a, 16b coplanar to the second base 14 of the stem 11.

In an alternative embodiment, the first and second resonator beams 15a and 15b can be positioned at a position intermediate from the second base 14 of the stem and from the first base 13 of the stem as shown in fig. 5b.

Advantageously, the thickness 17a, 17b of the first and second resonator beams is comprised between 0.05 µm and 25 µm, preferably less than 10 µm, more preferably less than 5 µm. More advantageously, the first and second resonator beams 15a, 15b have the same thickness.

Preferably, the height 12 of the stem 11 is comprised between 10 µm and 200 µm, preferably 20 µm to 150 µm, preferably between 80 µm and 125 µm.

Preferably, each of the first and second resonator beam 15a, 15b comprises :
- a main portion MP extending from their free end (unattached end) to a region at the proximity to their attached end and ;
- a flared portion FP extending from the main portion MP towards their attached end.

The length of the main portion MP and of the flared portion FP may vary in favor of each other from zero to the full length of the resonator beam.

The first and second resonator beams 15a, 15b are separated from each other by a gap 19 which can be constant between the main portions MP of the resonator beams 15a, 15b and which decrease between the flared portions FP of the resonator beams 15a, 15b. The flared portions FP of the resonator beams 15a, 15b improve shock resistance.

The width 20 of the stem 11 is comprised between 50 µm and 200 µm, preferably between 80 µm and 125 µm and is preferably wider than the sum of the widths of the first and second resonator beams 15a, 15b at their junction with the stem 11.

Preferably, the widths 18a, 18b of the main portions MP of each of the first and second resonator beams 15a, 15b is comprised between 10% and 45% of the width 20 of the stem 11. Advantageously, the widths 18a, 18b of the main portions MP of the first and second resonator beams 15a, 15b are the same.

Preferably, the tuning fork resonator has a length 21 inferior to 500 µm, preferably inferior to 400 µm.

The stem 11 has a thickness 30 measured in the direction of the resonator beams 15a, 15b. Each of the first and second resonator beams 15a, 15b has a length 23a, 23b which is superior or equal to at least half of the thickness 30 of the stem. Advantageously the first and second resonator beams 15a, 15b have the same length 23a, 23b.

Preferably, the stem 11 comprises a tapered portion 24 extending laterally from a side 25 of the stem and/or from one of the first base 13 or second base 14 of the stem 11 to a junction or an intermediate surface 26 between the stem 11 and the first and second resonator beams 15a, 15b, preferably a junction between the stem 11 and an intermediate slice 27 between the stem and the resonator beams 15a, 15b. A portion of length 22 comprises the thickness 30 of the stem, the width of the tapered portion 24 and the width of the intermediate slice 27 as shown in one embodiment of fig. 1 or fig. 5a and 5b. The portion of length 22 can be comprised between 5% and 60%, preferably 20% and 45% of the length 21 of the tuning fork resonator 10. As shown in one embodiment of fig. 2, one tapered portion 24 extends from a side 25 of the stem 11 at a position intermediate between the first base 13 and the second base 14, to a junction 26 between the intermediate slice 27 and the stem 11. As shown in another embodiment of Fig. 5b, a first tapered portion 24a extends from the second base 14 of the stem 11 to the intermediate slice 27, and a second tapered portion 24b extends from a location in between the first base 13 and the second base 14 of the stem, to the junction 26 between the stem 11 and the intermediate slice 27.

According to the invention, the tuning fork is configured such that to allow the resonator beams 15a, 15b to oscillate in an out-of-plane mode as described earlier. It should be noted that for the common Z-cut quartz used for tuning fork resonators, the piezoelectric coupling is very weak for out of plane modes. This applies even more regarding the small size. Consequently, direct excitation with electrodes on the quartz would yield very small motional capacitance, inhibiting operation in an oscillator circuit due to the small figure of merit. In order to obtain sufficient coupling and low resistance, small thin stripes of a piezoelectric material such as AlN (Aluminum nitride), PZT (lead zirconate titanate) or KNN (potassium sodium niobate) are deposited on the resonator plates and electrically linked to the mounting pads for excitation. An advantage of this approach is, that the piezoelectric coupling and the thermo-mechanical properties, i.e. the thermoelastic damping and the frequency-temperature behaviour can be optimised independently.

Preferably, each of the first and second resonator beams 15a, 15b further comprises a first piezoelectric assembly 28a and a second piezoelectric assembly 28b provided on their respective said surface 16a, 16b. Each of the first piezoelectric assembly 28a, 28b comprise :
- a first electrode layer 41a, 41b deposited on a surface 16a, 16b of the resonator beam 15a, 15b ;
- a piezoelectric layer 42a, 42b deposited over the first electrode 41a, 41b and ;
- a second electrode layer 43a, 43b deposited over the piezoelectric layer 42a, 42b.

The stem 11 further comprises a first mounting pad 29a and a second mounting pad 29b arranged preferably on the first base 13 of the said stem 11. As schematized in figure 3, the first mounting pad 29a is configured to be electrically coupled (or connected) to a first pole (not shown) of a source of electrical excitation (or electrical source), to the first electrode 41a of the first piezoelectric assembly 28a and to the second electrode 43b of the second piezoelectric strip assembly 28b. The second mounting pad 29b is configured to be electrically connected to an opposite pole (not shown) of the source of electrical excitation, to the second electrode 43a of the first piezoelectric assembly 28a and to the first electrode 41b of the second piezoelectric assembly 28b. Advantageously, the first piezoelectric assembly 28a and the second piezoelectric assembly 28b are at least partially located on the flared portions FP of the beam resonators 15a, 15b. The first and second piezoelectric assemblies 28a, 28b have preferably the shape of a strip.

In operation, the electrical excitation produces alternating electrical fields between the first 41a and the second electrodes 43a of the first piezoelectric assembly 28a the one hand, and between the first electrode 41b and the second electrode 43b of the second piezoelectric assembly 28b on the other hand. The alternating electrical fields cause the piezoelectric layers 42a, 42b of respectively the first and second piezoelectric assemblies 28a, 28b to shrink and expand cyclically in the longitudinal direction with a phase displacement of half a period between them.

While the piezoelectric layer 42a of the first piezoelectric strip assembly 28a expands longitudinally, the piezoelectric layer 42b of the second piezoelectric strip assembly 28b is shrinking, and the two resonator beams 15a, 15b are forced to bend downwards or upwards, away from the plane formed by the surfaces 16a, 16b of the beam resonators 15a, 15b when they are at rest.

One possible method for providing the piezoelectric assemblies 28a, 28b comprises the steps of forming a first metal film over the surface 16a, 16b of the resonator beams 15a, 15b. The metal film can be made from any adequate metal or alloy, chromium/gold or platinum for example. The film can be formed using a vacuum evaporation method, or sputtering, or any other adequate method known to the person skilled in the art. A piezoelectric thin film is then grown over the (entire) surface of the metal film. The piezoelectric thin films are preferably AIN or KNN or derivates of said materials. However, any other appropriate piezoelectric material can be used for the thin films. The thickness of the piezoelectric thin films preferably lies in the range between 0.05 and 3 µm; most preferably approximately 0.2 µm. A second metal film, possibly platinum, chromium or any other adequate layer matching the crystal lattice of the respective piezoelectric layer, is then deposited over the entire surface of each piezoelectric thin film. Preferably, a third metal film made of gold (Au) is then formed over the second metal film.

The entire surface of the outermost metal films can be covered with a photoresist, and the photoresist is patterned to form an etching mask on the side of the substrate. The structure formed by the substrate and the various films formed over its main surfaces is then etched layer by layer, by means of wet or dry etching. The remaining photoresist is then removed from the resonator (for example by immersing them in a solvent) exposing the metal films.

One possible way of implementing the connections between the electrodes layers and the mounting pads is to deposit conductive tracks of metal film using a vapor deposition mask or photolithographic techniques. Advantageously, in both piezoelectric assemblies, the position of the first electrode layer is longitudinally offset from the position of the second electrode layer such as to prevent their respective conductive track connections to interfere with each other.

One non-limitative example of an embodiment of a tuning fork resonator is made of a Z-cut quartz, and comprises a stem 11, a first resonator beam 15a and a second resonator beam 15b integral with the stem and extending from the stem towards a longitudinal direction perpendicular to the height 12 of the stem 11. The stem 11 has a height 12 of 100 µm and a width 20 of 100 µm. The first resonator beam 15a and a second resonator beam 15b have a thickness 17a, 17b of 1 µm, a main portion's width of 20 µm and a length of 150 µm. The first resonator beam 15a and the second resonator beam 15b extends parallel and symmetric to each other in the same longitudinal direction and their cantilevered portions are separated from each other by a gap 19 by 15 µm between their main portions MP. The total length of tuning fork including stem is of 370 µm. The first resonator beam 15a comprises a first piezoelectric assembly 28a and the second resonator beam 15b comprises a second piezoelectric assembly 28b deposited on their respective said surface 16a, 16b. Each of the first and second piezoelectric assemblies 28a, 28b comprises a first electrode layer 41 deposited on the surface 16a, 16b of the resonator beam 15a, 15b, a piezoelectric layer over the first electrode layer and a second electrode layer over the piezoelectric layer. The stem 11 further comprises a first mounting pad 29a and a second mounting pad 29b arranged on the first base 13 of the said stem 11. The first mounting pad 29a is electrically connected to a first electrode 41a of the first piezoelectric assembly 28a and a second electrode 43b of the second piezoelectric assembly 28b. The second mounting pad 29b is connected to the second electrode 43b of the first piezoelectric assembly 28a and to the first electrode 41b of the second piezoelectric assembly 28b. The tuning fork resonator is configured to vibrate in an out-of-plane mode.

The quality factor of the quartz tuning fork resonator as described in the example herein above has been compared with the quality factor of various quartz tuning fork resonators of prior art as shown in table 1 here below.

**Table 1:**

| Product | Total length of the tuning fork [µm] | width of the tuning fork [µm] | Quality factor at 32768Hz in vacuum |
|---|---|---|---|
| present invention | 370 | 100 | 15000 |
| CM10 | 860 | 680 | 14000 |
| CM9 | 1200 | 570 | 15000 |
| CM8 | 1460 | 610 | 20000 |
| CM7 | 2360 | 560 | 33000 |

According to the present invention, it has been made possible to reduce the overall dimensions of a quartz tuning fork resonator while keeping an acceptable quality factor at 32768 MHz superior to 10000, preferably superior or equal to 15000.

### Nomenclature

10 tuning fork resonator
11 stem
12 first height of stem
13 First base of stem
14 second base of stem
15a first resonator beam
15b second resonator beam
16a surface of 15a
16b surface of 15b
17a thickness of 15a
17b thickness of 15b
18a width of 15a
18b width of 15b
19 gap between main portions of 15a and 15b
20 width of the stem
21 length of the tuning fork resonator
22 width of the stem
23a length of 15a
23b length of 15b
24 tapered portion
24a first tapered portion
24b second tapered portion
25 lateral side of the stem
26 junction
27 intermediate slice
28a first piezoelectric strip assembly on 15a
28b second piezoelectric strip assembly on 15b
29a first mounting pad
29b second mounting pad
30 thickness of the stem
41a first electrode layer of 28a
42a piezoelectric layer of 28a
43a second electrode layer of 28a
41b first electrode layer of 28b
42b piezoelectric layer of 28b
43b second electrode layer of 28b
44a enlarged portion or mass of 16a
44b enlarged portion or mass of 16b

## Claims

1. Tuning fork resonator (10) comprising :
- a stem (11) having a first height (12) extending from a first base (13) to a second base (14), and ;
- a first resonator beam (15a) and a second resonator beam (15b) spaced from each other and coupled to the stem (11) and arranged in a plane substantially perpendicular to the height (12) of the stem (11) ;
**characterized in that** the first resonator beam (15a) and the second resonator beam (15b) have a thickness (17a, 17b) comprised between 0.05 % and 20% of the first height (12) of the stem (11).

2. Tuning fork resonator according to claim 1 configured such as to allow the resonator beams (15a, 15b) to oscillate in an out-of-plane mode.

3. Tuning fork resonator according to any one of the preceding claims wherein the first resonator beam (15a) comprises a first piezoelectric assembly (28a), and the second resonator beam (15b) comprises a second piezoelectric assembly (28b) provided on their respective said surface (16a, 16b), each of the first and second piezoelectric assemblies (28a, 28b) comprising :
- a first electrode layer (41a, 41b) over a surface (16a, 16b) of the resonator beam (15a, 15b) ;
- a piezoelectric layer (42a, 42b) over the first electrode (41a, 41b), and ;
- a second electrode layer (43a, 43b) over the piezoelectric layer (42a, 42b) ;
wherein :
- the first electrode layer (41a) of the first piezoelectric assembly (28a) and the second electrode layer (43b) of the second piezoelectric assembly are electrically coupled to a first mounting pad (29a) configured to be coupled to a first pole of an electrical source, and ;
- the second electrode layer (43a) of the first piezoelectric assembly (28a) and the first electrode layer (41b) of the second piezoelectric assembly (28b) are electrically coupled to a second mounting pad (29b) configured to be coupled to an opposite pole of the electrical source.

4. Tuning fork resonator according to any one of the preceding claims wherein the stem (11) and the resonator beams (15a, 15b) are made of quartz, preferably a Z-cut quartz or langasite, GaPO4 or partially oxidized silicon.

5. Tuning fork resonator according to claim 1 or 2 forming a body wherein the first resonator beam (15a) and the second resonator beam (15b) are integral with the stem (11).

6. Tuning fork resonator according to any one of the preceding claims further comprising an intermediate slice (27) extending between the stem (11) and the first and second resonator beams (15a, 15b), the intermediate slice (27) being coplanar with the first and second resonator beams (15a, 15b) and having preferably the same thickness as the resonator beams.

7. Tuning fork resonator according to any one of the preceding claims wherein the thickness (17a, 17b) of the first and second resonator beams (15a, 15b) is comprised between 0.05 µm and 25 µm, preferably less than 10 µm.

8. Tuning fork resonator according to any one of the preceding claims wherein the height (12) of the stem (11) is comprised between 10 µm and 200µm, preferably 20µm to 150µm, more preferably between 80 µm and 125 µm.

9. Tuning fork resonator according to any one of the preceding claims wherein each of the first and second resonator beam 15a, 15b have a first end fixed to the stem (11) or to a slice (27) between the stem and the resonator beams (15a, 15b), and a free end (unattached end), the first and second resonator beam further comprising :
- a main portion MP extending from their free end (unattached end) to a region at the proximity to their attached end, and ;
- a flared portion FP which widens from the main portion MP towards their attached end.

10. Tuning fork resonator according to any one of the preceding claims wherein the width (20) of the stem (11) is comprised between 50 µm and 200 µm, preferably between 80 µm and 125 µm.

11. Tuning fork resonator according to any one of the preceding claims wherein the width (18a, 18b) of the main portions MP of each of the first and second resonator beams (15a, 15b) is comprised between 20% and 45% of the width (20) of the stem (11).

12. Tuning fork resonator according to any one of the preceding claims having a length (21) inferior to 500 µm, preferably inferior to 400 µm.

13. Tuning fork resonator according to any one of the preceding claims wherein the stem (11) has a thickness (30) measured in the direction of the resonator beams (15a, 15b), and wherein each of the first and second resonator beams (15a, 15b) has a length (23a, 23b) which is superior or equal to at least half of the thickness (30) of the stem (11).

14. Tuning fork resonator according to any one of the preceding claims wherein the stem (11) comprises a tapered portion (24) extending from a lateral side (25) of the stem (11) and/or from one of the first base (13) or second base (14) to a junction or an intermediate surface (26) between the stem (11) and the first and second resonator beams (15a, 15b) or to a junction (26) or surface between the stem and a slice (27) connected to the resonator beams.

15. Tuning fork resonator according to any one of the preceding claims having a quality factor at 32768 Hz in vacuum which is superior or equal to 5000, preferably superior or equal to 7500, more preferably to superior or equal to 10000, even more preferably superior or equal to 15000.
